# EUROPÄISCHE PATENTANMELDUNG

(11) **EP 0 899 815 A2**
(43) Veröffentlichungstag der Anmeldung: **03.03.1999**
(21) Anmeldenummer: 98111468.9
(22) Anmeldetag: 22.06.1998
(51) Int. Cl.: H01Q 21/00, H01Q 3/26

(54) **Sendeempfangsmodul mit Temperaturkompensation für phasengesteuerte Antennen**

(30) Priorität: 27.08.1997 DE 19737361
(71) Anmelder: DAIMLER-BENZ AKTIENGESELLSCHAFT, 70567 Stuttgart (DE)
(72) Erfinder: Teufelhart, Johann, 82216 Rottbach (DE)

(57) **Zusammenfassung**

Die Erfindung betrifft ein Verfahren zur Steuerung von Phasenlage und/oder Amplitude für ein Sendesignal und/oder Empfangssignal in einem Sendeempfangsmodul (SEM), das zur Ansteuerung eines Antennenelementes (AE) dient, wobei in einer Steuereinrichtung (SE) des Sendeempfangsmoduls (SEM) aus Steuersignalen für Phasenlage und/oder Amplitude korrigierte Einstellwerte (KEW) gewonnen werden. Erfindungsgemäß werden die korrigierten Einstellwerte (KEW) unter Verwendung eines Interpolationsverfahrens und von in einem Einstellverfahren gewonnenen Stützwerten berechnet.

## Beschreibung

Die Erfindung betrifft ein Verfahren gemäß dem Oberbegriff des Patentanspruchs 1 sowie ein Sendeempfangsmodul gemäß dem Oberbegriff des Patentanspruchs 2.

Phasengesteuerte Antennen werden auch als elektronisch gesteuerte Gruppenantennen bezeichnet. Diese Antenne weisen eine Vielzahl von Antennenelementen beziehungsweise Einzelstrahlern auf. Jedem Einzelstrahler oder jeder kleinen Gruppe von Strahlern ist beispielsweise ein aktives Sendeempfangsmodul (T/R-Modul) zugeordnet. Durch die große Anzahl der Strahlerelemente wird die Apertur der Antenne gebildet.

Die Sendeempfangsmodule sind vorzugsweise durch Halbleiterbauelemente in hochintegrierter Mikrowellenschaltkreistechnik als sogenannte GaAs-MMIC (Gallium Arsenid monolithisch integrierte Mikrowellenschaltkreis) realisiert. Die aus physikalischen und operationellen Gründen vorgegebenen räumlichen Verhältnisse bei einer phasengesteuerten Antenne im Mikrowellenbereich bedingen, dass für jedes individuelle Sendeempfangsmodul nur ein stark begrenztes Einbauvolumen zur Verfügung steht. Aus diesem Grund sind hohe Anforderungen an die Miniaturisierung der Mikrowellenschaltkreise gestellt.

In den Steuereinrichtungen für die Phasen- und Amplitudensteuerung der T/R-Module kommt es zu einer temperaturbedingten Abweichung von der eingestellten Phasen- und/oder Amplitudengewichtung des Sende- und/oder des Empfangssignales. Auch Streuung und Alterung der Bauteile kann zu diesen Abweichungen führen. Damit die hohen Anforderungen an die Einstellgenauigkeit der T/R-Module erfüllt werden kann, müssen die Abweichungen des Istwertes vom vorgegebenen Sollwert korrigiert werden. Hierzu werden die Abweichungen bei einer Vielzahl von Einstellungen für die Phasenlage und die Amplitude der Sende- und des Empfangssignales ermittelt. Zur Zeit sind zur Korrektur ca. 100 000 Meßwerte notwendig. Der Speicherbedarf für die angelegte Korrekturwertetabelle ist vergleichsweise groß.

Der Erfindung liegt die Aufgabe zugrunde, ein Verfahren zur Steuerung von Phasenlage und/oder Amplitude für ein Sendeempfangsmodul sowie ein solches Sendeempfangsmodul anzugeben, bei dem der Platzbedarf weiter reduziert ist.

Diese Aufgabe wird erfindungsgemäß für ein Verfahren durch die Merkmale des Patentanspruchs 1 und für ein Sendeempfangsmodul durch die Merkmale des Patentanspruchs 2 gelöst.

Durch die Verwendung eines Interpolationsverfahrens beziehungsweise durch den im Sendeempfangsmodul vorgesehenen Rechenbaustein kann der Platzbedarf für das Modul weiter reduziert werden.

Im Folgenden wird die Erfindung anhand eines in der Zeichnung dargestellten Ausführungsbeispieles beschrieben. Dabei zeigen
- Figur 1: ein Sendeempfangsmodul gemäß dem Stand der Technik, und
- Figur 2: eine erfindungsgemäß ausgestaltete Steuereinrichtung für das Sendeempfangsmodul.

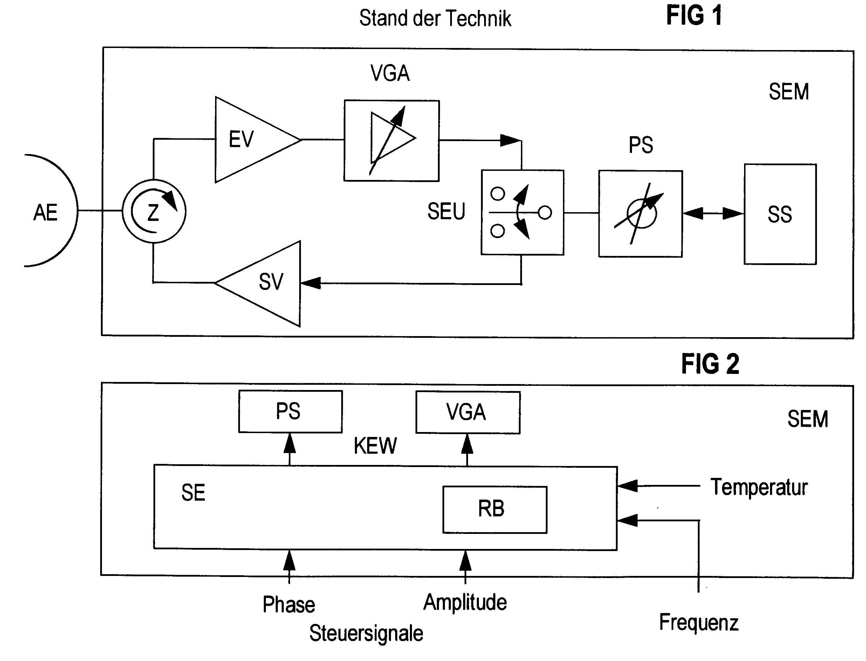

In Figur 1 ist zum Stand der Technik ein Sendeempfangsmodul SEM dargestellt. Es weist einen Zirkulator Z auf, an dem ein Antennenelement AE angeschaltet ist. Dieses Antennenelement AE gehört zu einer Vielzahl von Elementen, die zusammen eine nicht dargestellte phasengesteuere Antenne bilden.

Ein Speisesystem SS ist über einen bidirektionalen Phasenschieber PS mit einem Sendeempfangsumschalter SEU verbunden.

Der Sendeempfangsumschalter SEU ist in einem Sendezweig über einen Sendeverstärker SV mit dem Zirkulator Z verbunden. Weiter ist der Zirkulator Z in einem Empfangszweig über einen Empfangsverstärker EV und einen nachgeschalteten Verstärker VGA mit einstellbarer Verstärkung mit dem Sendeempfangsumschalter SEU verbunden. Durch den Sendeempfangsumschalter SEU ist das Antennenelement AE wahlweise im Sendebetrieb über den Sendezweig und im Empfangsbetrieb über den Empfangszweig am Phasenschieber PS angeschaltet.

Der Phasenschieber PS dient zur Strahlsteuerung im Sende- und im Empfangsbetrieb, und der einstellbare Verstärker VGA dient zur Wichtung der einzelnen Empfangssignale des Antennenelementes AE. Der Sendeverstärker SV dient zur Erzeugung der HF-Leistung im Sendezweig. Der Empfangsverstärker EV im Empfangszweig sowie der Sendeempfangsumschalter SEU und der Zirkulator Z dienen zur Trennung von Sende- und Empfangszweig. Durch den bidirektionalen Phasenschieber PS ist die Phaseneinstellung sowohl im Sende- als auch im Empfangsweg mit einem einzigen Baustein möglich.

Bei der folgenden Beschreibung wird auch auf die Figur 2 Bezug genommen.

Zur Einstellung der Phasenlage und/oder der Amplitude ist im Sendeempfangsmodul SEM eine Steuereinrichtung SE vorgesehen. An dieser Steuereinrichtung SE liegen Steuersignale für die Phase, für die Amplitude und für die Frequenz an. Zur Einhaltung verschiedener Modulspezifikationen sind Kompensationsmaßnahmen erforderlich. Zum Einen müssen der Temperatur- und der Frequenzgang der Komponenten, zum Anderen Exemplarstreuungen ausgeglichen werden. Ein weiterer Kompensationsbedarf entsteht dadurch, dass sich die Einfügephase des Vertärkers VGA bei verschiedenen Verstärkungseinstellungen und die Einfügedämpfung des Phasenschiebers PS bei verschiedenen Phaseneinstellungen ändert. Um diese Effekte zu eliminieren sind in der Steuereinrichtung SE sogenannten 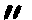 Look-Up" Tabellen vorhanden, die ausgehend von der geforderten Einstellung (Phase/Amplitude) unter Berücksichtigung der aktuellen Temperatur und der Frequenz die korrigierten Einstellungen an den Verstärker VGA und dem Phasenschieber PS ausgeben. Die Steuereinrichtung SE bildet aus den Steuersignalen für die Phase und für die Amplitude korrigierte Einstellwerte KEW, die am Phasenschieber PS und am Verstärker VGA anliegen.

Damit die hohen Anforderungen an das Sendeempfangsmodul SEM im Hinblick auf Phasen- und Amplitudengenauigkeit erfüllt werden können, müssen die auftretenden Abweichungen des Istwerts vom gewünschten Sollwert korrigiert werden. Die hierzu verwendete 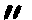 Look-up" Tabelle beziehungsweise Korrekturwertetabelle wird in einem sehr umfangreichen und zeitaufwendigen Messverfahren ermittelt. Für eine vollständige Korrekturwertetabelle sind etwa 100000 Messwerte notwendig.

Erfindungsgemäß werden die korrigierten Einstellwerte KEW für die Phase und/oder die Amplitude unter Verwendung eines Interpolationsverfahrens ermittelt. Es werden nur noch wenige Messreihen an bestimmten Stützpunkten durchgeführt. Die dazwischenliegenden Werte werden durch lineare oder auch nicht lineare Abhängigkeiten interpoliert. Diese Abhängigkeiten werden durch eine exemplarische Messung ermittelt und in der Steuereinrichtung SE abgelegt.

Durch die Erfindung wird die Zahl der erforderlichen Messungen auf ein Bruchteil reduziert und ein großer Teil des Logikschaltkreises für die Korrekturwertetabelle eingespart.

Zur Durchführung des Interpolationsverfahrens weist die Steuereinrichtung SE beispielsweise einen Rechenbaustein RB auf. In diesem Rechenbaustein RB ist das Interpolationsverfahren durch eine sogenannte Festverdrahtung realisiert. Hierdurch ist der Platzbedarf gegenüber der 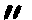 Look-up" Tabelle reduziert.

## Patentansprüche

1. Verfahren zur Steuerung von Phasenlage und/oder Amplitude für ein Sendesignal und/oder Empfangssignal in einem Sendeempfangsmodul (SEM), das zur Ansteuerung eines Antennenelementes (AE) dient, wobei in einer Steuereinrichtung (SE) des Sendeempfangsmoduls (SEM) aus Steuersignalen für Phasenlage und/oder Amplitude korrigierte Einstellwerte (KEW) gewonnen werden,
**dadurch gekennzeichnet,**
daß die korrigierten Einstellwerte (KEW) unter Verwendung eines Interpolationsverfahrens und von in einem Einstellverfahren gewonnenen Stützwerten berechnet werden.

2. Sendeempfangsmodul (SEM) für ein Antennenelement (AE), mit einer Steuereinrichtung (SE) zur phasenmäßigen und/oder amplitudenmäßigen Ansteuerung eines Sendesignals und/oder eines Empfangssignals wobei die Steuereinrichtung (SE) zur Bildung von korrigierten Einstellwerten (KEW) aus Steuersignalen für Phasenlage und/oder Amplitude dient,
**dadurch gekennzeichnet,**
dass die Steuereinrichtung (SE) einen Rechenbaustein (RB) aufweist, in dem die korrigierten Einstellwerte (KEW) unter Verwendung eines Interpolationsverfahrens und von gespeicherten Stützwerten berechenbar sind.

3. Sendeempfangsmodul nach Anspruch 2,
**dadurch gekennzeichnet,**
dass der Rechenbaustein (RB) durch einen programmierbaren Baustein realisiert ist.
